(19) Europäisches Patentamt
European Patent Office
Office européen des brevets

(11) **EP 2 426 880 B1**

(12) **EUROPÄISCHE PATENTSCHRIFT**

(45) Veröffentlichungstag und Bekanntmachung des Hinweises auf die Patenterteilung:
**17.05.2017  Patentblatt 2017/20**

(51) Int Cl.:
*H04L 27/22* *(2006.01)*      *G01H 9/00* *(2006.01)*
*H03D 3/00* *(2006.01)*      *H04L 27/26* *(2006.01)*

(21) Anmeldenummer: **11006952.3**

(22) Anmeldetag: **25.08.2011**

(54) **Demodulationsverfahren**

Demodulation method

Procédé de démodulation

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.09.2010  DE 102010044245**

(43) Veröffentlichungstag der Anmeldung:
**07.03.2012  Patentblatt 2012/10**

(73) Patentinhaber: **KROHNE Messtechnik GmbH 47058 Duisburg (DE)**

(72) Erfinder: **Gossner, Kai 47506 Neukirchen-Vluyn (DE)**

(74) Vertreter: **Gesthuysen Patent- und Rechtsanwälte Patentanwälte Postfach 10 13 54 45013 Essen (DE)**

(56) Entgegenhaltungen:
**US-A1- 2003 063 679      US-A1- 2007 103 692**

## Beschreibung

Die Erfindung betrifft ein Demodulationsverfahren für ein pseudo-heterodynes Signal gemäß dem Oberbegriff von Patentanspruch 1.

Ein gattungsgemäßes Demodulationsverfahren ist beispielsweise bekannt aus der US 2003/00663679 A1, auch hier wird eine Phaseninformation aus der geometrischen Auswertung von Ergebnis-Fourierkoeffizienten gewonnen.

Als ein pseudo-heterodynes Signal wird ein solches Signal bezeichnet, das von einem auf einem pseudo-heterodynen Verfahren basierenden Interferometer ausgegeben wird. Bekanntlich werden mit einem Interferometer zwei zeitlich hinreichend kohärente - d.h. interferenzfähige - Strahlen zur Interferenz gebracht. Prinzipiell wird die Strahlung einer kohärenten Strahlungsquelle mit einem Strahlteiler in einen ersten Teilstrahl und einen zweiten Teilstrahl aufgeteilt. Die Wege, die der erste Teilstrahl und der zweite Teilstrahl zurücklegen, werden als Arme des Interferometers bezeichnet. Am Ausgang des Interferometers werden die Teilstrahlen zusammengeführt und zur Interferenz gebracht (bzw. Strahlen zur Interferenz gebracht, die - je nach Konstruktion des Interferometers - von den Teilstrahlen abgeleitet worden sind). Die Strahlungsintensität am Ausgang des Interferometers ist proportional zum Kosinus der Phasendifferenz der beiden interferierenden Teilstrahlen. Änderungen der Phasendifferenz, z. B. hervorgerufen durch kleinste Änderungen der Länge eines Interferometerarmes, führen somit zu einer Intensitätsänderung am Ausgang des Interferometers.

Bei dem eingangs erwähnten pseudo-heterodynen Verfahren wird die Phasendifferenz zwischen den beiden im Interferometer interferierenden Teilstrahlen mit einem periodischen Sägezahnsignal moduliert. Grundsätzlich sind auch andere Signaltypen möglichen, jedoch ist die Verwendung eines Sägezahnsignals die bekannteste und am weitesten verbreitete Methode, so dass die Beschreibung im Folgenden auf die Verwendung eines Sägezahnsignals abzielt, die Erfindung ist darauf jedoch nicht beschränkt. Als Sägezahnsignal wird ein Signal z(t) bezeichnet, welches durch folgende Fourierreihe beschrieben werden kann:

$$ z(t) = a \sum_{k=1}^{\infty} \frac{\sin(2\pi k f_0 t)}{k} \qquad\qquad (\text{Glg. } 1) $$

Hier bezeichnet a einen von Null verschiedenen Skalierungsfaktor, $f_0$ die Frequenz des periodischen Sägezahnsignals und t die Zeit. Wie aus der Fourierreihe des Sägezahnsignals z(t) ersichtlich ist, treten auch Frequenzen auf, die einem ganzzahligen Vielfachen der Frequenz $f_0$ entsprechen. Dem Phasendifferenzsignal, das aus der Modulation der als konstant angenommenen Phasendifferenz mit dem bekannten Sägezahnsignal z(t) hervorgegangen ist, wird das eigentlich interessierende Nutzsignal s(t) überlagert, das grundsätzlich in der - wie auch immer verursachten - Phasenänderung eines Teilstrahls in einem Arm des Interferometers besteht. Das Intensitätssignal am Ausgang des Interferometers ist nun das pseudo-heterodyne Signal. Bei verschwindendem Nutzsignal geht das pseudo-heterodyne Signal in das unmodulierte Trägersignal über, welches im Wesentlichen aus sich periodisch wiederholenden sinusförmigen Abschnitten zusammengesetzt ist. Als die Frequenz des Trägersignals wird hierbei die Frequenz der periodischen Wiederholung der sich wiederholenden sinusförmigen Abschnitte bezeichnet. Diese Frequenz entspricht der Frequenz $f_0$ des periodischen Sägezahnsignals z(t). Bei vorhandenem Nutzsignal ist das Trägersignal durch das Nutzsignal phasenmoduliert.

Als Interferometer werden häufig Mach-Zehnder-Interferometer verwendet. Andere Interferometertypen, beispielsweise Michelson-Interferometer, sind grundsätzlich auch denkbar. Für die Erzeugung der im Interferometer verwendeten Strahlung eignen sich insbesondere Halbleiterlaser, wie z. B. VCSEL (Vertical-Cavity Surface-Emitting Laser). Der Vorteil von Halbleiterlasern besteht darin, dass die Modulation der Phasendifferenz zwischen den beiden im Interferometer interferierenden Teilstrahlen sich besonders einfach realisieren lässt. Hierzu wird die Eigenschaft von Halbleiterlasern genutzt, dass die Wellenlänge der vom Halbleiterlaser emittierten Laserstrahlung vom Pumpstrom abhängt. So kann, durch Amplitudenmodulation des Pumpstroms mit einem entsprechenden Signal, der Wellenlänge der Laserstrahlung das gewünschte Sägezahnsignal z(t) aufmoduliert werden. Die Änderung der Phasendifferenz $d\phi$ zwischen den beiden im Interferometer interferierenden Teilstrahlen hängt, bei einem vorhandenem Weglängenunterschied *l* der beiden Teilstrahlen, mit der Änderung der Frequenz der Laserstrahlung *dv* linear zusammen:

$$ d\phi = \frac{2\pi n l}{c} dv \qquad\qquad (\text{Glg. } 2) $$

Hier bezeichnet n den durchschnittlichen Brechungsindex entlang der Strecke des Weglängenunterschiedes *l*, und c bezeichnet die Vakuumlichtgeschwindigkeit. Daher ergibt sich, dass der Phasendifferenz zwischen den beiden im Interferometer interferierenden Teilstrahlen durch entsprechende Modulation des Pumpstroms des Halbleiterlasers das gewünschte Sägezahnsignal z(t) aufmoduliert werden kann. Dieses Modulationsverfahren funktioniert nur bei nicht verschwindendem Weglängenunterschied *l* der beiden Teilstrahlen. Der Vorteil dieses Modulationsverfahrens liegt darin, dass keine beweglichen und störanfälligen Bauteile zur Modulation der Phasendifferenz zwischen den beiden im Interferometer interferierenden Teilstrahlen notwendig ist, sondern ausschließlich elektronische Komponenten Verwendung finden.

Das pseudo-heterodyne Signal, das zunächst als Intensitätssignal am Ausgang des Interferometers vorliegt, wird üblicherweise durch eine Photodiode, insbesondere eine PIN-Photodiode, in ein elektrisches Signal umgewandelt. Daraufhin wird dieses elektrische Signal, nach eventueller Verstärkung, digital abgetastet. Die digitale Abtastung wird insbesondere durch einen Analog-Digital-Wandler vorgenommen. Eine eventuell vorgesehene Verstärkung kann auch direkt durch die PIN-Photodiode erfolgen.

Das zuvor beschriebene interferometrische Verfahren zur Erzeugung eines pseudo-heterodynen Signals ist beispielsweise für solche Anwendungen geeignet, bei denen geringe Auslenkungen zu detektieren sind, wobei das Interferometer so eingesetzt wird, dass die zu detektierende Auslenkung zu einer Weglängenänderung eines Interferometerarms führt; dadurch sind ohne weiteres Auslenkungen im (Sub-)Wellenlängenbereich der eingesetzten Strahlenquelle detektierbar. Anwendungen des Verfahrens liegen insofern beispielsweise im Bereich der Vibrationsmessung, insbesondere bei Vibrationsmessgeräten bzw. bei Messgeräten, die mechanische Schwingungen erfassen, wobei die Art bzw. Änderung der erfassten Schwingungen Rückschluss auf andere interessierende Größen geben kann. Als eine solche Anwendung ist z. B. die Wirbelfrequenz-Durchflussmessung denkbar. Im Folgenden wird diese Anwendung beispielhaft erläutert. Dies stellt selbstverständlich aber keine Einschränkung des erfindungsgemäßen Verfahrens dar, vielmehr ist eine Vielzahl anderer Anwendungsmöglichkeiten denkbar, wie z. B. die Anwendung in akustischen Sensoren.

Mit einem Wirbelfrequenz-Durchflussmessgerät, kann der Volumendurchfluss von Gasen, Dämpfen und Flüssigkeiten in Rohrleitungen gemessen werden. Das Messprinzip basiert auf dem Prinzip der Kärmänschen Wirbelstraße. Im Messrohr befindet sich ein vom Medium umströmter Störkörper, hinter dem sich Wirbel ablösen. Die Frequenz f der Wirbelablösung ist proportional zur Durchflussgeschwindigkeit v des Mediums. Die dimensionslose Strouhal-Zahl S beschreibt den Zusammenhang zwischen Wirbelfrequenz f, Breite b des Wirbelkörpers und der mittleren Durchflussgeschwindigkeit v des Mediums:

$$f = \frac{S \cdot v}{b} \qquad\qquad (\text{Glg. } 3)$$

Die sich hinter dem Störkörper in Strömungsrichtung ausbreitenden Wirbel wirken auf eine in Strömungsrichtung hinter dem Störkörper befindliche Sonde, wie z. B. eine Membran oder eine stabförmige Sonde. Die Sonde wird durch die Wirbel mit der Frequenz f, die das Nutzsignal darstellt, periodisch ausgelenkt. Diese Auslenkung kann beispielsweise mechanisch auf einen Spiegel eines Armes eines Interferometers außerhalb des Messrohres übertragen werden, sie kann aber auch direkt durch eine optische Faser erfasst werden, die auf der auslenkbaren Membran befestigt ist und entsprechend der Auslenkung einer Längenänderung unterliegt. Die derart erfasste Auslenkung sorgt so für eine periodische Veränderung der Phasendifferenz zwischen den beiden im Interferometer interferierenden Teilstrahlen. Diese periodische Veränderung der Phasendifferenz entspricht dem interessierenden Nutzsignal.

Ein derartiges Wirbelfrequenz-Durchflussmessgerät ist aus der WO 92/01208 bekannt. Die Demodulation des pseudo-heterodynen Signals erfolgt hierbei durch einen Phasenregelkreis (Phase-Locked Loop, PLL). Als nachteilig bei diesem Demodulationsverfahren hat sich erwiesen, dass der Phasenregelkreis sich auf höhere Harmonische des pseudo-heterodynen Signals einstellen kann und zwischen verschiedenen Harmonischen hin und her springt. Hierdurch wird die Signalqualität stark beeinträchtigt. Zwar können die höheren Harmonischen aus dem pseudo-heterodynen Signal entfernt werden, dies erhöht jedoch den schaltungstechnischen Aufwand.

Da im Bereich der Spitze eines Sägezahns des Sägezahnsignals z(t), nach erreichen der maximalen Amplitude, die Amplitude des Pumpstroms sprungartig abfällt, führt dies in der Regel auch zu einer sprungartige Änderung des pseudo-heterodynen Signals. Bei einer eventuell vorgesehenen Verstärkung des pseudo-heterodynen Signals, kann mit einem Verstärker, der eine hohe Bandbreite aufweist, die sprungartige Änderung des pseudo-heterodynen Signals relativ störungsarm erfasst werden, d. h. die Sprungantwort des Verstärkers führt zu relativ geringen Störungen. Ein Verstärker mit einer hohen Bandbreite weist jedoch in der Regel einen unerwünscht hohen Energieverbrauch auf, so dass die vorbeschriebene Technologie praktisch nicht anwendbar ist bei Geräten, die bestimmungsgemäß nur eine sehr geringe maximale Leistungsaufnahme haben (dürfen), beispielsweise Zweileitergeräte mit einer Stromschnittstelle (4 mA - 20 mA).

Damit ist es die Aufgabe der Erfindung, ein Demodulationsverfahren anzugeben, das die aus dem Stand der Technik bekannten Nachteile zumindest teilweise vermeidet, wenigstens jedoch eine Alternative zu den aus dem Stand der Technik bekannten Verfahren darstellt.

Die zuvor hergeleitete und aufgezeigte Aufgabe ist ausgehend von dem eingangs beschriebenen Demodulationsverfahren dadurch gelöst, dass das pseudo-heterodyne Signal über (m+p/n)-Schwingungen des Trägersignals erzeugt wird, das pseudo-heterodyne Signal mit der m*n+p-fachen Frequenz des Trägersignals abgetastet wird, wobei m eine natürliche Zahl größer als Null ist, n eine natürliche Zahl größer als eins ist und p eine natürliche Zahl größer als Null ist, die diskrete Fouriertransformation über m*n Abtastschritte durchgeführt wird und die ersten p Abtastschritte verworfen wird.

Den erfindungsgemäßen Schritten vorgelagert ist, dass das digital abgetastete pseudo-heterodyne Signal einer diskreten Fouriertransformation unterzogen wird und mindestens ein Amplitude und Phase aufweisender Ergebnis-Fourierkoeffizient ermittelt wird, auf genau einen Ergebnis-Fourierkoeffizient der diskreten Fouriertransformierten eine atan2-Funktion angewendet wird und die atan2-Funktion als Ergebnis die Phase des einen Ergebnis-Fourierkoeffizienten liefert. Da jeder Fourierkoeffizient einer Fouriertransformation eine Phaseninformation enthält, ist es ausreichend, lediglich einen Fourierkoeffizienten zu berechnen. Die atan2-Funktion ist hierbei eine Funktion, die angewendet auf eine komplexe Zahl, wie z. B. einen Fourierkoeffizienten einer diskreten Fouriertransformierten, die Phase dieser komplexen Zahl liefert. Da das pseudo-heterodyne Signal mit dem Nutzsignal phasenmoduliert ist, kann aus der Phaseninformation des einen Ergebnis-Fourierkoeffizienten, die von der atan2-Funktion geliefert wird, in bekannter Weise das Nutzsignal gewonnen werden.

Allgemein ist es möglich die atan2-Funktion auf einen beliebigen Ergebnis-Fourierkoeffizienten anzuwenden, da alle Ergebnis-Fourierkoeffizienten eine Phaseninformation enthalten. Gemäß einer vorteilhaften Weiterbildung der Erfindung ist jedoch vorgesehen, dass der eine Ergebnis-Fourierkoeffizient der zweite Fourierkoeffizient der diskreten Fouriertransformierten ist.

Eine vorteilhafte Ausgestaltung der Erfindung zeichnet sich dadurch aus, dass zur Erzeugung der diskreten Fouriertransformierten ein Algorithmus zur schnellen Fouriertransformation verwendet wird. Mit einem Algorithmus zur schnellen Fouriertransformation, die üblicher weise als FFT (Fast Fourier Transform) abgekürzt wird, ist ein Algorithmus gemeint, der die diskrete Fouriertransformation nach dem "teile-und-herrsche"-Prinzip äußerst schnell berechnen kann. Insbesondere ist es vorteilhaft, den verwendeten Algorithmus auf die spezielle Form der zu berechnenden diskreten Fouriertransformation anzupassen, um so eine weitere Geschwindigkeitserhöhung zu erreichen.

Bei einer nicht zur Erfindung gehörenden Variante eines Demodulationsverfahrens ist vorgesehen, dass das pseudo-heterodyne Signal über m Schwingungen des Trägersignals erzeugt wird, das pseudo-heterodyne Signal mit der m*n-fachen Frequenz des Trägersignals abgetastet wird, wobei m eine natürliche Zahl größer als Null ist und n eine natürliche Zahl größer als eins ist, und die diskrete Fouriertransformation über m*n Abtastschritte durchgeführt wird. Dass das pseudo-heterodyne Signal über m Schwingungen des Trägersignals erzeugt wird, bedeutet hierbei, dass die Modulation der Phasendifferenz zwischen den beiden im Interferometer interferierenden Teilstrahlen mit einem derartigen Sägezahnsignal erfolgt, dass die sich periodisch wiederholenden sinusförmigen Abschnitte des Trägersignals jeweils m Schwingungen einer Sinusschwingung entsprechen. Dies kann durch eine geeignete Wahl der Steigung der Sägezähne des Sägezahnsignals z(t) erreicht werden. Die Steigung der Sägezähne des Sägezahnsignals z(t) kann über den Skalierungsfaktor a (siehe Gleichung 1) eingestellt werden.

Demgegenüber ist bei der erfindungsgemäßen Ausgestaltung vorgesehen, dass das pseudo-heterodyne Signal über (m+p/n)-Schwingungen des Trägersignals erzeugt wird, das pseudo-heterodyne Signal mit der m*n+p-fachen Frequenz des Trägersignals abgetastet wird, wobei m eine natürliche Zahl größer als Null ist, n eine natürliche Zahl größer als eins ist und p eine natürliche Zahl größer als Null ist, die diskrete Fouriertransformation über m*n Abtastschritte durchgeführt wird und die ersten p Abtastschritte verworfen wird.

Durch Verwerfen eines der m*n+p-Abtastschritte kann ein Teil des sich periodisch wiederholenden sinusförmigen Abschnittes ausgeblendet werden. Da die Störungen durch die Sprungantwort eines Verstärkers stets unmittelbar nach der sprunghaften Änderung des pseudo-heterodynen Signals auftreten, wird hierfür erfindungsgemäß gerade der Teil des sich periodisch wiederholenden sinusförmigen Abschnittes gewählt, der die durch die Sprungantwort des Verstärkers hervorgerufenen Störungen enthält. Dieser Teil entspricht in der Regel den ersten p Abtastschritten der m*n+p Abtastschritte. Diese ersten p Abtastschritte werden bei der nachfolgenden diskreten Fouriertransformation nicht berücksichtigt, d. h. verworfen. Die übrigen m*n Abtastschritte werden für die diskrete Fouriertransformation verwendet. Der verbleibende Teil des sich periodisch wiederholenden sinusförmigen Abschnittes stellt nun genau m Perioden einer Sinusschwingung dar. Dieser verbleibende, äußerst störungsarme Teil wird erfindungsgemäß mit der atan2-Funktion ausgewertet. Hieraus folgt, dass auch Verstärker mit einer geringen Bandbreite und somit einem geringeren Energiebedarf verwendet werden können, da die durch die Sprungantwort des Verstärkers hervorgerufenen Störungen nahezu vollständig unterdrückt werden.

Insgesamt ist festzustellen, dass durch das erfindungsgemäße Verfahren die Möglichkeit geschaffen wird, Interferometrie-Anwendungen auch bei solchen Geräten zu realisieren, die bestimmungsgemäß nur eine sehr geringe maximale Leistungsaufnahme haben (dürfen), wie die zuvor erwähnten Zweileitergeräte mit einer Stromschnittstelle (4 mA - 20 mA).

Bei gegebener Zahl m und gegebener Zahl n kann der optimale Wert der Zahl p wie folgt bestimmt werden. Der Wert der Zahl p wird genau dann als optimal bezeichnet, wenn die Zahl p gerade so groß ist, dass die durch die Sprungantwort des Verstärkers hervorgerufenen Störungen unterdrückt werden. Zur Bestimmung des optimalen Werts der Zahl p wird die Gesamtdauer $t_d$ des sich periodisch wiederholenden sinusförmigen Abschnittes und die Dauer $t_{sr}$ der zu unterdrückenden Störungen bestimmt. Mit der Kenntnis dieser beiden Zeitdauern und der gegebenen Zahl m sowie der gegebenen Zahl n kann der optimale Wert der Zahl p gemäß Gleichung 4 bestimmt werden.

$$p = \left\lceil \frac{m \cdot n \cdot t_{sr}}{(t_d - t_{sr})} \right\rceil \qquad \text{(Glg. 4)}$$

Hierbei wird durch die hochgestellte Klammer die Aufrundungsfunktion symbolisiert, so dass sich gemäß Gleichung 4 stets ein ganzzahliger Wert für p ergibt.

Gemäß einer weiteren bevorzugten Ausgestaltung der Erfindung ist vorgesehen, dass die Zahl n gleich vier gewählt wird. Darüber hinaus ist es vorteilhaft, wenn die Zahl m gleich eins gewählt wird. Bei einer besonders vorteilhaften Ausgestaltung der Erfindung ist vorgesehen, dass die Zahl p gleich eins gewählt wird.

Gemäß einer weiteren bevorzugten Weiterbildung der Erfindung ist vorgesehen, dass das pseudo-heterodyne Signal vor der digitalen Abtastung von einem Verstärker verstärkt wird. Die Verstärkung des pseudo-heterodynen Signals vor der digitalen Abtastung ist insbesondere dann notwendig, wenn die Signalstärke für eine fehlerfreie digitale Abtastung nicht ausreicht.

Bei einer vorteilhaften Ausgestaltung der Erfindung ist vorgesehen, dass das pseudo-heterodyne Signal vor der digitalen Abtastung mit einem Tiefpassfilter gefiltert wird. Durch die Verwendung eines Tiefpassfilters vor der digitalen Abtastung des pseudo-heterodynen Signals können möglicherweise störende höhere Harmonische des pseudo-heterodynen Signals herausgefiltert werden. Hierdurch werden insbesondere Aliasing-Effekte wirksam unterdrückt.

Gemäß einer weiteren vorteilhaften Ausgestaltung der Erfindung ist vorgesehen, dass Phasensprünge in der Phase des einen Ergebnis-Fourierkoeffizienten durch Phase Unwrapping entfernt werden. Mit einem Phase Unwrapping Algorithmus lassen sich Phasenänderungen handhaben, die größer sind als $2\pi$. Derartige Algorithmen sind aus dem Stand der Technik hinreichend bekannt.

Im Einzelnen gibt es nun eine Vielzahl von Möglichkeiten, das erfindungsgemäße Demodulationsverfahren auszugestalten und weiterzubilden. Dazu wird auf die dem Patentanspruch 1 nachgeordneten Patentansprüche sowie auf die nachfolgende detaillierte Beschreibung bevorzugter Ausführungsbeispiele der Erfindung unter Bezugnahme auf die Zeichnung verwiesen.

In der Zeichnung zeigt

Fig. 1 schematisch ein auf einem pseudo-heterodynen Verfahren basierendes Interferometer,

Fig. 2 schematisch das erfindungsgemäße Demodulationsverfahren anhand eines bevorzugten Ausführungsbeispiels,

Fig. 3 schematisch das erfindungsgemäße Demodulationsverfahren anhand eines weiteren vorteilhaften Ausführungsbeispiels und

Fig. 4 schematisch die Anwendung des erfindungsgemäßen Demodulationsverfahren gemäß des weiteren vorteilhaften Ausführungsbeispiels anhand eines beispielhaften pseudo-heterodynen Signals.

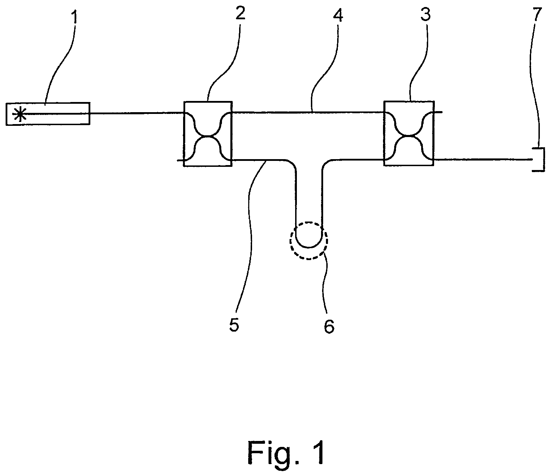

Aus der Fig. 1 ist schematisch ein auf einem pseudo-heterodynen Verfahren basierendes Interferometer ersichtlich, mit einem Halbleiterlaser 1, einem ersten Strahlteiler 2, einem zweiten Strahlteiler 3, einem ersten Interferometerarm 4 und einem zweiten Interferometerarm 5. Der Halbleiterlaser 1 erzeugt ein in der Frequenz sägezahnförmig moduliertes Lasersignal, welches dem ersten Strahlteiler 2 zugeführt wird. Der erste Strahlteiler 2 spaltet das Lasersignal in zwei Teilstrahlen auf, die dem ersten Interferometerarm 4 bzw. dem zweiten Interferometerarm 5 zugeführt werden.

Der zweite Interferometerarm 5, der eine von der Länge des ersten Interferometerarms 4 abweichende Länge aufweist, ist über eine Wechselwirkungsstelle 6 beeinflussbar. An dieser Wechselwirkungsstelle 6 wird der zweite Interferometerarm 5 derart beeinflusst, dass ein Nutzsignal, welches beispielsweise von einem Vibrationsmessgerät stammt, dem Phasendifferenzsignal der beiden Lasersignale in dem ersten Interferometerarm 4 und dem zweiten Interferometerarm 5 überlagert ist. Die Beeinflussung an der Wechselwirkungsstelle 6 kann z. B. dadurch erfolgen, dass die Weglänge, die das Lasersignal in dem zweiten Interferometerarm 5 zurücklegen muss in Abhängigkeit von dem Nutzsignal verändert wird. Das Intensitätssignal am Ausgang des Interferometers ist nun das pseudo-heterodyne Signal und ist im Wesentlichen aus sich periodisch wiederholenden sinusförmigen Abschnitten zusammengesetzt, die mit dem Nutzsignal phasenmoduliert sind. Dieses pseudo-heterodyne Ausgangssignal des Interferometers wird mit einer PIN-Photodiode 7 detektiert und in ein elektrisches Signal umgewandelt.

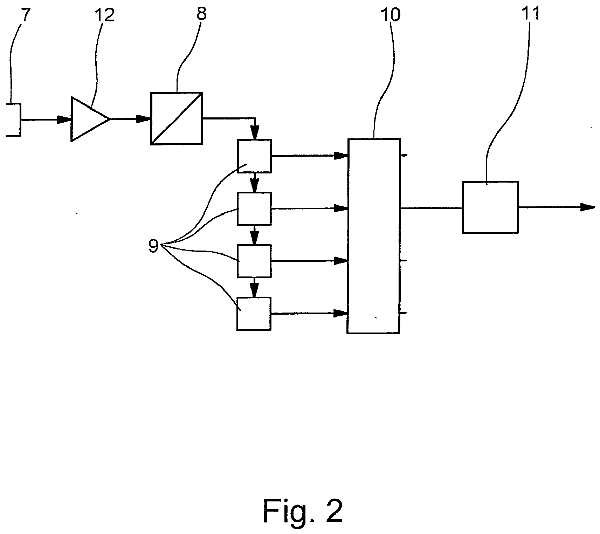

Fig. 2 zeigt schematisch nach der Art eines Flussdiagramms das erfindungsgemäße Demodulationsverfahren anhand eines bevorzugten Ausführungsbeispiels. Nach der Digitalisierung des durch die PIN-Photodiode 7 in ein elektrisches Signal umgewandelten pseudo-heterodynen Signals mittels eines Analog-Digital-Wandlers 8, wird das pseudo-heterodyne Signale einer aus Verzögerungseinheiten 9 gebildeten Verzögerungskette zugeführt. Die Abtastrate des Analog-Digital-Wandlers 8 beträgt hierbei das Vierfache der Frequenz des Trägersignals, d. h. des Sägezahnsignals. Dementsprechend sind auch vier Verzögerungseinheiten 9 in der Verzögerungskette vorgesehen.

Bei jedem Abtastschritt des Analog-Digital-Wandlers 8 übergibt der Analog-Digital-Wandler 8 einen Abtastwert an die mit ihm verbundene Verzögerungseinheit 9. Dieser Abtastwert wird in der mit ihm verbundenen Verzögerungseinheit 9 gespeichert. Gleichzeitig übergibt jede Verzögerungseinheit 9 den in ihr gespeicherten Abtastwert an die nächste Verzögerungseinheit 9 in der Verzögerungskette und jede Verzögerungseinheit 9 in der Verzögerungskette speichert den Abtastwert, den sie hierbei erhält. Nach jeweils vier Abtastschritten übergeben alle Verzögerungseinheiten 9 der Verzögerungskette ihren jeweiligen Abtastwert an eine Einrichtung zur schnellen Fouriertransformation 10. Die Einrichtung zur schnellen Fouriertransformation 10 berechnet lediglich den zweiten Fourierkoeffizienten der diskreten Fouriertransformierten und übergibt diesen an eine atan2-Funktion 11.

Die atan2-Funktion 11 berechnet die Phase des zweiten Fourierkoeffizienten der diskreten Fouriertransformierten. Da jeder Fourierkoeffizient einer Fouriertransformation eine Phaseninformation enthält, ist es ausreichend, lediglich einen Fourierkoeffizienten zu berechnen. Die des zweiten Fourierkoeffizienten der diskreten Fouriertransformierten ist das Ausgangssignal des erfindungsgemäßen Demodulationsverfahrens, welches hier zur Veranschaulichung teils mit gegenständlichen Merkmalen beschrieben wurde. Aus der Phase des zweiten Fourierkoeffizienten der diskreten Fouriertransformierten lässt sich mit aus dem Stand der Technik bekannten Mitteln das Nutzsignal gewinnen. Das Nutzsignal ist beispielsweise die Frequenz f eines auf der Erfassung von mechanischen Schwingungen beruhenden Messgeräts.

Falls notwendig kann das pseudo-heterodyne Signal vor der digitalen Abtastung durch den Analog-Digital-Wandler 8 durch einen Verstärker 12 verstärkt werden. Zusätzlich oder alternativ zu einer Verstärkung kann das pseudo-heterodyne Signal vor der digitalen Abtastung durch den Analog-Digital-Wandler 8 mit einem hier nicht dargestellten Tiefpassfilter gefiltert werden.

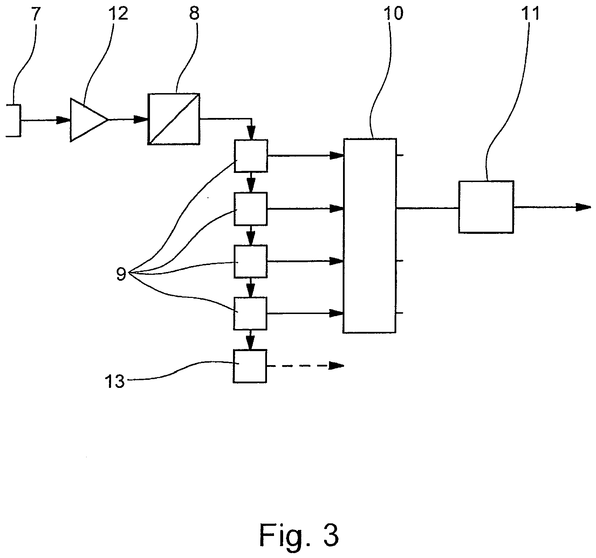

Aus Fig. 3 ist schematisch ein weiteres vorteilhaftes Ausführungsbeispiel des erfindungsgemäßen Demodulationsverfahrens ersichtlich. Strukturell entspricht das Flussdiagramm der Fig. 3 im Wesentlichen dem Flussdiagramm der Fig. 2. Lediglich eine weitere Verzögerungseinheit 13 ist der Verzögerungskette zugeordnet. Im Gegensatz zu dem in der Fig. 2 dargestellten Demodulationsverfahren arbeitet der Analog-Digital-Wandler 8 des in der Fig. 3 dargestellten Demodulationsverfahrens mit der 4+1-fachen Abtastrate des Trägersignals. Hierdurch werden, bei angenommener gleicher Frequenz des Trägersignals, von dem Analog-Digital-Wandler 8 fünf statt nur vier Abtastwerte wie in der Fig. 2 ermittelt. Nach jeweils fünf Abtastschritten übergeben die Verzögerungseinheiten 9 der Verzögerungskette die in ihn gespeicherten Abtastwerte an die Einrichtung zur schnellen Fouriertransformation 10. Der Abtastwert, der in der weiteren Verzögerungseinheit 13 gespeichert ist, wird hierbei verworfen. Erfindungsgemäß enthält jedoch genau dieser Abtastwert den wesentlichen Teil der auftretenden Störungen.

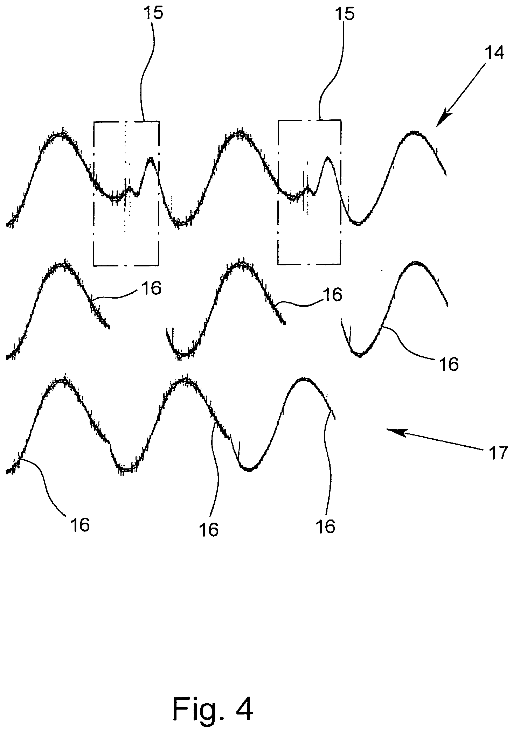

In Fig. 4 ist ein Signalausschnitt 14 eines pseudo-heterodynen Signals gezeigt, das z. B. als elektrisches Signal am Ausgang einer PIN-Photodiode ausgegeben wird, die das Intensitätssignal eines pseudo-heterodynen Interferometers empfängt. Der Signalausschnitt 14 des pseudo-heterodynen Signals weist Störbereiche 15 auf, die die durch die Sprungantwort des Verstärkers hervorgerufenen Störungen enthalten. Gemäß eines weiteren vorteilhaften Ausführungsbeispiels des erfindungsgemäßen Demodulationsverfahrens werden bei der diskreten Fouriertransformation gerade die Abtastschritte, die diesen Störbereichen 15 entsprechen, nicht berücksichtigt, d. h. verworfen. Dies ist in Fig. 4 dadurch veranschaulicht, dass aus dem Signalausschnitt 14 des pseudo-heterodynen Signals die Störbereiche 15 in der zweiten Zeile entfernt sind und die verbleibenden im Wesentlichen sinusförmigen ungestörten Signalabschnitte 16 zu einem störungsarmen Auswertesignal 17 in der dritten Zeile der Fig. 4 zusammengesetzt werden.

**Bezugszeichenliste**

1    Halbleiterlaser
2    erster Strahlteiler
3    zweiter Strahlteiler
4    erster Interferometerarm
5    zweiter Interferometerarm
6    Wechselwirkungsstelle
7    PIN-Photodiode
8    Analog-Digital-Wandler

9    Verzögerungseinheit
10   Einrichtung zur schnellen Fouriertransformation
11   atan2-Funktion
12   Verstärker
13   weitere Verzögerungseinheit
14   Signalausschnitt
15   Störbereiche
16   ungestörte Signalabschnitte
17   Auswertesignal

**Patentansprüche**

1.  Demodulationsverfahren für ein pseudo-heterodynes Signal, wobei das pseudo-heterodyne Signal ein phasenmoduliertes Trägersignal aufweist, wobei das Trägersignal aus sich periodisch wiederholenden sinusförmigen Abschnitten zusammengesetzt ist und das pseudo-heterodyne Signal digital abgetastet wird, wobei das digital abgetastete pseudo-heterodyne Signal einer diskreten Fouriertransformation unterzogen wird und mindestens ein Amplitude und Phase aufweisender Ergebnis-Fourierkoeffizient ermittelt wird, auf genau einen Ergebnis-Fourierkoeffizient der diskreten Fouriertransformierten eine atan2-Funktion (11) angewendet wird und die atan2-Funktion (11) als Ergebnis die Phase des einen Ergebnis-Fourierkoeffizienten liefert,
    **dadurch gekennzeichnet,**
    **dass** das pseudo-heterodyne Signal über (m+p/n)-Schwingungen des Trägersignals erzeugt wird, das pseudo-heterodyne Signal mit der m*n+p-fachen Frequenz des Trägersignals abgetastet wird, wobei m eine natürliche Zahl größer als Null ist, n eine natürliche Zahl größer als eins ist und p eine natürliche Zahl größer als Null ist, die diskrete Fouriertransformation über m*n Abtastschritte durchgeführt wird und die ersten p Abtastschritte verworfen wird.

2.  Demodulationsverfahren nach Anspruch 1, **dadurch gekennzeichnet, dass** der eine Ergebnis-Fourierkoeffizient der zweite Fourierkoeffizient der diskreten Fouriertransformierten ist.

3.  Demodulationsverfahren nach Anspruch 1 oder 2, **dadurch gekennzeichnet, dass** zur Erzeugung der diskreten Fouriertransformierten ein Algorithmus zur schnellen Fouriertransformation verwendet wird.

4.  Demodulationsverfahren nach einem der Ansprüche 1 bis 3, **dadurch gekennzeichnet, dass** die Zahl n gleich vier gewählt wird.

5.  Demodulationsverfahren nach einem der Ansprüche 1 bis 4, **dadurch gekennzeichnet, dass** die Zahl m gleich eins gewählt wird.

6.  Demodulationsverfahren nach einem der Ansprüche 1 bis 5, **dadurch gekennzeichnet, dass** die Zahl p gleich eins gewählt wird.

7.  Demodulationsverfahren nach einem der Ansprüche 1 bis 6, **dadurch gekennzeichnet, dass** das pseudo-heterodyne Signal vor der digitalen Abtastung von einem Verstärker verstärkt wird.

8.  Demodulationsverfahren nach einem der Ansprüche 1 bis 7, **dadurch gekennzeichnet, dass** das pseudo-heterodyne Signal vor der digitalen Abtastung mit einem Tiefpassfilter gefiltert wird.

9.  Demodulationsverfahren nach den Ansprüchen 1 bis 8, **dadurch gekennzeichnet, dass** Phasensprünge in der Phase des einen Ergebnis-Fourierkoeffizienten durch Phase Unwrapping entfernt werden.

**Claims**

1.  Demodulation method for a pseudo-heterodyne signal, wherein the pseudo-heterodyne signal has a phase-modulated carrier signal, wherein the carrier signal is composed of periodically repeating sinusoidal sections and the pseudo-heterodyne signal is digitally sampled, wherein the digitally sampled pseudo-heterodyne signal is subjected to a discrete Fourier transformation and at least one output Fourier coefficient featuring an amplitude and phase is determined, one atan2 function (11) is applied on exactly one output Fourier coefficient of the discrete Fourier transformation and the atan2 function (11) provides the phase of the one output Fourier coefficient as a result, **characterized in**

**that** the pseudo-heterodyne signal is created during (m+p/n)-oscillations of the carrier signal, the pseudo-heterodyne signal is sampled with the m*n+p-fold frequency of the carrier signal, wherein m is a natural number greater than zero, n is a natural number greater than one and p is a natural number greater than zero, the discrete Fourier transformation is carried out over m*n sampling steps and the first p sampling steps are discarded.

2. Demodulation method according to claim 1, **characterized in that** the one output Fourier coefficient is the second Fourier coefficient of the discrete Fourier transformation.

3. Demodulation method according to claim 1 or 2, **characterized in that** an algorithm for fast Fourier transformation is used for creating the discrete Fourier transformation.

4. Demodulation method according to any one of claims 1 to 3, **characterized in that** the number n is chosen equal to four.

5. Demodulation method according to any one of claims 1 to 4, **characterized in that** the number m is chosen equal to one.

6. Demodulation method according to any one of claims 1 to 5, **characterized in that** the number p is chosen equal to one.

7. Demodulation method according to any one of claims 1 to 6, **characterized in that** the pseudo-heterodyne signal is amplified by an amplifier before digital sampling.

8. Demodulation method according to any one of claims 1 to 7, **characterized in that** the pseudo-heterodyne signal is filtered by a low-pass filter before digital sampling.

9. Demodulation method according to claims 1 to 8, **characterized in that** phase steps in the phase of the one output Fourier coefficient are removed by phase unwrapping.

**Revendications**

1. Procédé de démodulation pour un signal pseudo-hétérodyne, selon lequel le signal pseudo-hétérodyne présente un signal de porteuse modulé en phase, selon lequel le signal de porteuse est composé de sections sinusoïdales qui se répètent périodiquement et le signal pseudo-hétérodyne est balayé de manière numérique, selon lequel le signal pseudo-hétérodyne balayé de manière numérique est soumis à une transformation de Fourier discrète et au moins un résultat de coefficient de Fourier présentant une amplitude et une phase est déterminé, une fonction atan2 (11) est appliquée sur exactement un résultat de coefficient de Fourier de la transformée de Fourier discrète et la fonction atan2 (11) fournit la phase du résultat de coefficient de Fourier sous la forme d'un résultat, **caractérisé en ce que**

le signal pseudo-hétérodyne est généré par l'intermédiaire d'oscillations de type (m+p/n) du signal de porteuse, le signal pseudo-hétérodyne est balayé par la fréquence multipliée par m*n+p du signal de porteuse, où m est un entier naturel supérieur à zéro, n est un entier naturel supérieur à un et p est un entier naturel supérieur à zéro, où la transformation de Fourier discrète est réalisée par l'intermédiaire de phases de balayage de type m*n et les premières phases de balayage p sont rejetées.

2. Procédé de démodulation selon la revendication 1, **caractérisé en ce que** le résultat de coefficient de Fourier est le deuxième coefficient de Fourier de la transformée de Fourier discrète.

3. Procédé de démodulation selon la revendication 1 ou 2, **caractérisé en ce qu'**un algorithme destiné à la transformation de Fourier rapide est employé en vue de la génération de la transformée de Fourier discrète.

4. Procédé de démodulation selon l'une des revendications 1 à 3, **caractérisé en ce que** le nombre « n égal quatre » est sélectionné.

5. Procédé de démodulation selon l'une des revendications 1 à 4, **caractérisé en ce que** le nombre « m égal un » est sélectionné.

6. Procédé de démodulation selon l'une des revendications 1 à 5, **caractérisé en ce que** le nombre « p égal un » est sélectionné.

7. Procédé de démodulation selon l'une des revendications 1 à 6, **caractérisé en ce que** le signal pseudo-hétérodyne est amplifié par un amplificateur se trouvant en amont du balayage numérique.

8. Procédé de démodulation selon l'une des revendications 1 à 7, **caractérisé en ce que** le signal pseudo-hétérodyne est filtré au moyen d'un filtre passe-bas se trouvant en amont du balayage numérique.

9. Procédé de démodulation selon les revendications 1 à 8, **caractérisé en ce que** des sauts de phase sont supprimés durant la phase du résultat de coefficient de Fourier par l'intermédiaire d'un procédé de « Phase Unwrapping ».

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 200300663679 A1
- WO 9201208 A